# EUROPEAN PATENT SPECIFICATION

(11) **EP 2 336 389 B1**
(45) Date of publication and mention of the grant of the patent: **21.05.2014**
(21) Application number: 10194536.8
(22) Date of filing: 10.12.2010
(51) Int. Cl.: C23C 16/455

(54) **A showerhead assembly for vacuum processing apparatus**
Duschkopfanordnung für Vakuumverarbeitungsvorrichtung
Ensemble de pommeau de douche pour appareil de traitement sous vide

(30) Priority: 10.12.2009 US 285505 P
(43) Date of publication of application: 22.06.2011
(73) Proprietor: Orbotech LT Solar, LLC, San Jose, California 95119 (US)
(72) Inventor: Blonigan, Wendell Thomas, Pleasanton, CA 94566 (US); Renta, Michael Allen, Campbell, CA 95008 (US)
(74) Representative: Kirschner, Klaus Dieter

(56) References cited:
- EP-A1- 1 422 317
- US-A- 6 036 782
- US-A1- 2005 183 827

## Description

The invention concerns a vacuum processing apparatus, such as plasma chambers used for etching or forming thin films on substrates or other workpieces.

Manufacturing processes in the fields of semiconductor, flat panel displays, solar panels, etc., involve processing in vacuum chambers. For example, vacuum chambers are used for plasma-enhanced chemical vapor deposition (PECVD), plasma etching and various other processes for forming thin films on substrates (workpieces) and etching structures on the substrates. In such chambers, various gases are flowed into the chamber, either via injectors or via a showerhead. For uniform plasma processing in large chambers, a showerhead is preferable over injectors. The showerhead would generally cover substantially the entire ceiling of the chamber, so that even amount of gas is injected everywhere within the chamber.
As gas is flowed into the chamber, plasma is ignited and sustained using radio frequency or microwave energy. This heats up the chamber. Also, for many processes active heaters are used to heat the substrates, which further add to heating of the chamber. Of course, when the processed substrates are removed from the chamber and fresh ones are introduced into the chamber, the chamber cools down until plasma is ignited again. These changes in temperatures cause various parts of the chamber to expand and contract. Parts made of different material would expand and contract at different rates. Also, large parts in large chamber would expand considerably. This is especially true for showerheads of large processing chambers, such as those used for fabrication of flat panel displays or solar cell. EP 1422317 (A1) shows a gas processing apparatus 1 which includes a processing container 2 for applying a processing to a wafer W while using a processing gas, a mount table 5 arranged in the processing container 2 to mount the wafer W, a shower head 22 arranged corresponding to the wafer W on the mount table 5 to discharge the processing gas into the processing container 2 and exhausting means 132 for exhausting the interior of the processing container 2. The shower head 22 has first gas discharging holes 46 arranged corresponding to the wafer W mounted on the mount table 5 and second gas discharging holes 47 arranged around the first gas discharging holes 46 independently to discharge the processing gas to the peripheral part of the wafer W. Thus, with a uniform gas supply to a substrate, it is possible to perform a uniform gas processing.

Embodiments of the invention provide vacuum processing chambers having provisions for thermal expansion and contraction. Specific embodiments of the invention provide a plasma processing chamber having a showerhead that enables thermal expansion and contraction without imparting structural stress on the chamber body and without breaking any gas seal.

According to an embodiment of the invention, a plasma chamber is provided wherein the showerhead assembly anchors the showerhead at one point, while allowing sliding of the shower at other points in order to allow for thermal expansion and contraction. According to another embodiment, no anchoring is provided, and the showerhead may slide in all directions while maintaining gas seal.

According to an embodiment of the invention, a vacuum processing chamber is provided, comprising the features of claim 1.

According to an embodiment of the invention, a method for securing a showerhead assembly onto a vacuum processing chamber is provided, comprising the features of claim 14.

Other aspects and features of the invention will become apparent from the description of various embodiments described herein, and which come within the scope of the invention as claimed in the appended claims.
Figure 1 is a schematic illustrating major elements of a plasma processing chamber implementing an embodiment of the invention.
Figure 2 is a cross section illustrating one example of anchoring one side of the showerhead, according to an embodiment of the invention.
Figure 3 is a cross section illustrating one example of floating one side of the showerhead, according to an embodiment of the invention.
Figure 4 is an explosive view illustrating a floating mechanism according to an embodiment of the invention.
Figure 5 is an isometric view of the assembled floating attachment.
Figure 6 is a lower elevation of the cover plate 176, showing its underside.
Figures 7A and 7B are bottom elevation view of the back plate and the showerhead plate according to an embodiment of the invention.

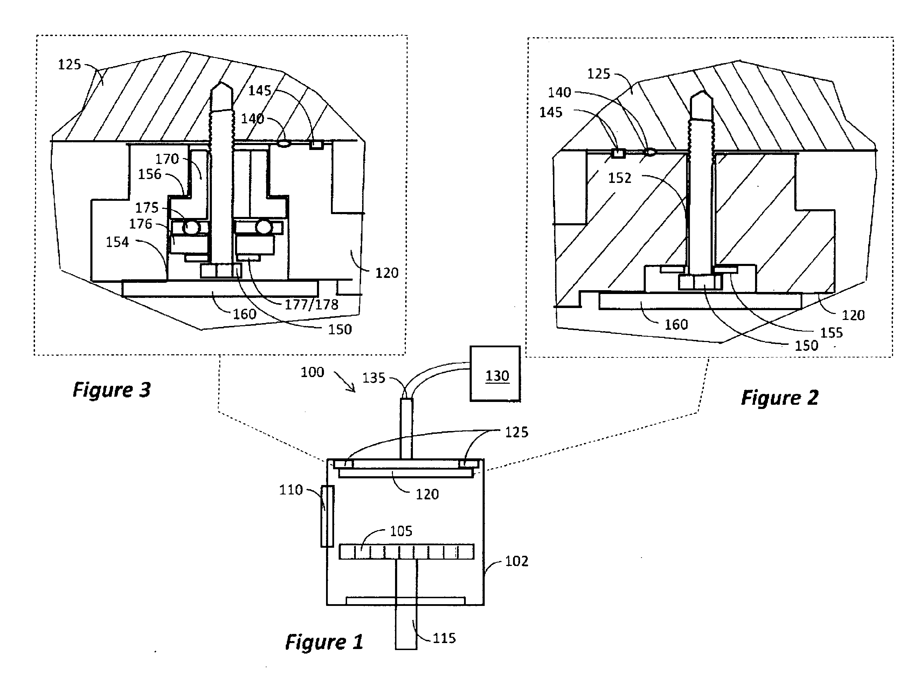

Figure 1 is a schematic illustrating major elements of a plasma processing chamber 100 implementing an embodiment of the invention. The chamber 100 includes a chamber body 102, generally made of metal, such as aluminum, stainless steel, etc. A pedestal 105 is provided for holding one or more substrates. The pedestal 105 may support a susceptor, a chuck, and/or a heater. The pedestal may be attached to a lift mechanism 115, so that it is lowered to the illustrated position for substrates loading via the valve 110, and then lifted up for processing. At its top, the chamber has a showerhead assembly that includes a showerhead plate 120 attached to a back plate 125. The back plate 125 is secured hermetically to the chamber body 102. Gas is supplied to the showerhead from source 130, via conduit 135. The showerhead plate 120 has many perforations that allow the gas to disperse into the chamber.

Figure 2 is a cross section illustrating one example of anchoring one location of the showerhead plate 120 to the back plate 125, according to an embodiment of the invention. According to an embodiment of the invention, at least one point of the shower plate 120 is anchored to the back plate 125, such that it is sealed to the back plate 125 to avoid gas leaks, and such that it cannot move relative to the back plate 125 at that point. This point may be, for example, one of the corners or the center of the showerhead plate. The illustration of Figure 2 shows the example of anchoring at one corner of the showerhead plate.

Figure 3, on the other hand, shows example of the sliding fastening assemblies used to slidingly attach the showerhead to the backplate, according to an embodiment of the invention. That is, in this embodiment, at least the diametrically opposing side of the showerhead plate 120 is attached to the back plate 125 in a floating manner, such that it is sealed to the back plate 125, but can slide with respect to the back plate 125 at that location. In this manner, expansion and contraction of the showerhead plate 120 is enabled, as it is free to slide with respect to the back plate 125, while still keeping the seal to it to avoid processing gas escaping from between the showerhead plate and the back plate.

As shown in Figures 2 and 3, an o-ring 140 is provided between the showerhead plate 120 and back plate 125, so as to provide gas seal between the showerhead plate 120 and the back plate 125. A Teflon block or spacer 145 is also provided between the showerhead plate 120 and the back plate 125, such that it maintains a small gap between the showerhead plate 120 and the back plate 125, enabling sliding motion therebetween. In Figure 2, the showerhead plate 120 is securely bolted to the back plate 125 using bolt 150 and washer 155. A cover 160 is provided to cover the bolt 150.

Figure 3 illustrate the sliding fastening assembly that is used to attach the showerhead plate 120 to the back plate 125 in a manner providing gas seal but allowing sliding of the showerhead plate 120 for thermal expansion and contraction. While in Figure 2 a hole 152 having a diameter just sufficient to accommodate the bolt 150 is drilled in the showerhead plate, for the sliding fastening assembly illustrated in Figure 3 the hole 154 is of oval shape and includes a step 156. An insert 170 is inserted into the hole 154, such that it is seated against the step 156. The insert may be made of ceramic or other material.

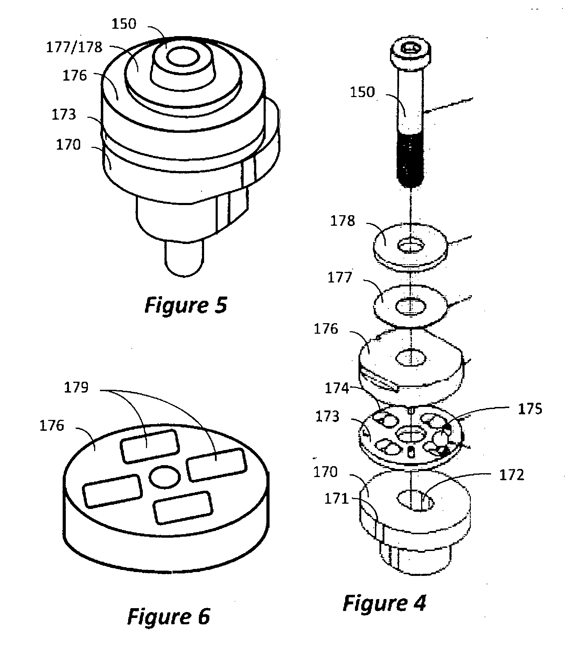

Figure 4 is an exploded view of the sliding fastening mechanism according to one embodiment of the invention. As shown in Figure 4, the insert 170 has a hole 172 that is of slightly larger diameter than the diameter of the bolt 150 and is oval in shape. Also, as shown in Figure 4, the insert 170 includes a key 171, so that it can be inserted into hole 154 in only one orientation, such that the long axis of the oval hole 172 is in the direction of expansion of the showerhead plate 120 at that location.

A sliding plate 173 is provided over the insert 170. The sliding plate 173 has four oval holes 174, which are also oriented in the direction of sliding. In each of the holes, a ball 175 is inserted. Each ball 175 can ride freely inside its respective oval hole 174. A cover plate 176 is provided over the assembly of the sliding plate 173 and balls 175. It can be appreciated that the insert 170, sliding plate 173, balls 175 and cover plate 176, essentially form a "linear" ball bearing arrangement. Two optional washers 177, 178 are provided over the cover plate 176, and a bolt 150 tightens the entire assembly onto the back plate 125. As can be understood, under proper tightening of the bold 150, the showerhead plate 120 can be sealed to the backplate 150, but also be able to expand by sliding with respect to the backplate 125. When this occurs, the assembly of showerhead plate 120 and insert 170 "ride" on balls 175, since the hole 172 provided in the insert 170 is oval in the direction of expansion motion. In this embodiment, all of the parts, except for the bolt 150, are made of ceramic, but other materials may be used for the various parts, such as aluminum, anodized aluminum, Teflon, etc.

Figure 5 illustrates the entire sliding fastening arrangement with bolt 150 inserted thorough the washers 177/178, the cover plate 176, the sliding plate 173, and the insert 170. This entire assembly is inserted into the hole 154, shown in Figure 3, and the bolt is tightened so as to form a seal with o-ring 140, but allow sliding of the showerhead plate 120, assisted by the Teflon block.

Figure 6 is a lower elevation of the cover plate 176, showing its underside. As shown in Figure 6, according to one embodiment, four races are provided on the bottom face of the cover plate, such that the balls 175 can freely roll in one linear direction dictated by the race.

According to another embodiment, the showerhead plate is not fixedly attached to the back plate. Rather, a plurality of sliding fastening assemblies are used to attach the showerhead plate to the back plate, so that it is free to expand in all directions. However, the plurality of sliding fastening assemblies are oriented such that the center of the showerhead plate remains at the same location regardless of expansion or contraction of the showerhead plate. This is illustrated in Figures 8A and 8B.

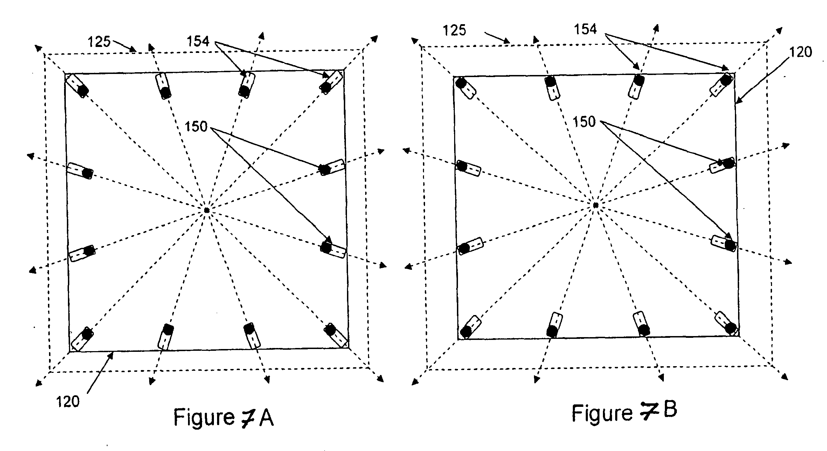

Figures 7A and 7B are bottom elevation views of the back plate 125 (shown in broken line) and the showerhead plate 120 according to an embodiment of the invention. The broken-line arrows illustrate straight-line directions from the center of the showerhead plate, extending radillay and passing through the center of each point where a fastening assembly is provided. As illustrated, each of the oval holes 154 of the fastening assembly is oriented such that its long axis lies along the straight line extending radially from the center of the showerhead plate. As explained above, each of the inserts 170 includes a key, such that when it is inserted into a hole 154 it assumes an orientation so that the long axis of its oval hole 172 is also oriented along the straight line extending radially from the center of the showerhead plate. In this manner, at each point where a fastening assembly is provided, the showerhead can slide only along the direction of the straight line extending radially from the center of the showerhead plate and passes through that point. Consequently, it can be understood that the showerhead can expand and contract in all directions by sliding or riding on the fastening assemblies, but because of the orientation of the fastening assemblies the center of the showerhead remains at the same location regardless of the expansion and contraction of the showerhead plate. That is, the orientations of the fastening mechanisms prevent any rotation or translation of the showerhead plate, other than radial expansion and contraction.

Figure 7A illustrate the showerhead plate in its expanded position. As shown, the showerhead plate has expanded such that the bolts 150 are on the inner-radial side of the oval holes 154. Conversely, in Figure 7B, illustrating the contracting position, the bolts 150 are shown at the outer-radial side of the oval holes 154.

While the invention has been described with reference to particular embodiments thereof, it is not limited to those embodiments. Specifically, various variations and modifications may be implemented by those of ordinary skill in the art without departing from the scope, as defined by the appended claims.

## Claims

1. A vacuum processing chamber, comprising:
a chamber body (102);
a showerhead assembly (120,125) coupled to top portion of the chamber body (102); and,
wherein the showerhead assembly (120,125) comprises:
a back plate (125) rigidly attached to the chamber body (102);
a perforated showerhead plate (120);
a plurality of fastening assemblies (150, 170, 173,176, 177, 178) slidingly securing the showerhead plate (120) to the back plate (125) such that the showerhead plate (120) may slide with respect to the back plate (125);wherein gas seal is maintained between the showerhead plate (120) and the back plate (125)
**characterized in that**
each of the fastening assemblies (150, 170, 173,176, 177, 178) comprises a ball bearing assembly and a bolt (150) passing through the ball bearing assembly.

2. The vacuum processing chamber of claim 1, wherein the perforated showerhead plate (120) comprises a plurality of oval holes (154) at periphery thereof, and wherein each one of the plurality of fastening assemblies (150, 170, 173,176, 177, 178) is inserted in a respective one of the plurality of oval holes (154).

3. The vacuum processing chamber of claim 1 or 2, wherein the showerhead assembly (120,125) further comprises an o-ring (140) provided between the showerhead plate (120) and the back plate (125).

4. The vacuum processing chamber of claim 1, 2 or 3, wherein the showerhead assembly (120,125) further comprises a spacer (145) provided between the showerhead plate (120) and the back plate (125) to thereby maintain a small gap between the showerhead plate (120) and the back plate (125).

5. The vacuum processing chamber of any of claims 1 to 4, wherein the showerhead plate (120) further comprises a circular hole (152) and a bolt (150) passing through the circular hole (152) and fixedly securing the showerhead plate (120) to the back plate (125).

6. The vacuum processing chamber of any of claims 2 to 5, wherein the each of the plurality of oval holes (154) is oriented such that its long axis lies along a straight line extending radially from the center of the showerhead plate (120) and passing through that oval hole (154).

7. The vacuum processing chamber of claim 1, wherein each of the fastening assemblies (150, 170, 173,176, 177, 178) comprises a key (171) to enable only one orientation when the fastening assembly (150, 170, 173,176, 177, 178) is seated within its respective oval hole (154).

8. The vacuum processing chamber of claim 1, wherein the ball bearing assembly comprises:
an insert (170) having an oval hole (172) therein;
a sliding plate (173) having a plurality of non-circular holes (174) therein;
a plurality of balls (175), each for a corresponding one of the non-circular holes (174);
a cover plate (176) having a circular hole therein.

9. The vacuum processing chamber of claim 8, wherein the insert (170) further comprises a key (171) to orient the insert inside one of the oval holes (154) of the showerhead plate (120).

10. The vacuum processing chamber of claim 8, wherein at least one of the insert (170), sliding plate (173), plurality of balls (175), and cover plate (176), is made of ceramic.

11. The vacuum processing chamber of any of claims 8 to 10, further comprising a covering plate (160) for covering the fastening assembly (150, 170, 173,176, 177, 178).

12. The vacuum processing chamber of claim 1, wherein each of the fastening assembly (150, 170, 173,176, 177,178) comprises:
an insert (170) having an oval hole (172) therein and a sliding surface;
a cover plate (176) having a mating surface facing the sliding surface; and,
a bolt (150) passing through the insert (170) and the cover plate (176).

13. The vacuum processing chamber of claim 1, wherein each of the fastening assemblies (150, 170, 173,176, 177, 178) further comprises a sliding plate (173) inserted between the insert (170) and the cover plate (176), wherein the sliding plate (173) preferably comprises a Teflon plate.

14. A method for securing a showerhead assembly (120,125) onto a vacuum processing chamber (100), comprising:
fixedly attaching a back plate (125) to the vacuum processing chamber (100);
coupling a perforated showerhead plate (120) to the back plate (125) by using a plurality of fastening assemblies (150, 170, 173,176, 177, 178) to slidingly attach the perforated showerhead plate (120) to the back plate (125); and
providing a gas seal between the perforated showerhead plate (120) and the back plate (125) **characterized in that**
the slidingly attaching comprises bolting the perforated showerhead plate (120) to the back plate (125) via a ball bearing assembly.

15. The method of claim 14, further comprising inserting a spacer (145) between the perforated showerhead plate (120) and the back plate (125).

16. The method of claim 15, further comprising orienting each of the ball bearing assemblies such that it is aligned with an imaginary line extending radially from the center of the showerhead plate (120).

17. The method of claim 14, further comprising fixedly affixing the showerhead plate (120) to the back plate (125) at one point.

## Patentansprüche

1. Vakuumverarbeitungskammer umfassend:
einen Kammerkörper (102);
eine Duschkopfanordnung (120, 125), die an dem oberen Teil des Kammerkörpers (102) gekoppelt ist; und,
wobei die Duschkopfanordnung (120, 125) umfasst:
eine Stützplatte (125), die fest an dem Kammerkörper (102) befestigt ist;
eine perforierte Duschkopfplatte (120);
eine Vielzahl von Befestigungsanordnungen (150, 170, 173, 176, 177, 187), die die Duschkopfplatte (120) gleitbar an der Stützplatte (125) befestigen, sodass die Duschkopfplatte (120) in Bezug auf die Stützplatte (125) gleiten kann; wobei eine Gasdichtung zwischen der Duschkopfplatte (120) und der Rückstützplatte (125) aufrechterhalten wird,
**dadurch gekennzeichnet dass**,
jede der Befestigungsanordnungen (150, 170, 173, 176, 177, 178) eine Kugellageranordnung und einen Bolzen (150) äufweist, der durch die Kugellageranordnung hindurchreicht.

2. Vakuumverarbeitungskammer nach Anspruch 1, worin die perforierte Duschkopfplatte (120) eine Vielzahl von ovalen Löchern (154) an ihrer Peripherie aufweist, und worin jede der Vielzahl der Befestigungsanordnungen (150, 170, 173, 176, 177, 178) in ein respektives der Vielzahl der ovalen Löcher (154) eingesetzt ist.

3. Vakuumverarbeitungskammer nach Anspruch 1 oder 2, worin die Duschkopfanordnung (120, 125) ferner einen O-Ring (140) aufweist, der zwischen der Duschkopfplatte (120) und der Stützplatte (125) vorgesehen ist.

4. Vakuumverarbeitungskammer nach Anspruch 1, 2 oder 3, worin die Duschkopfanordnung (120, 125) ferner ein Abstandsstück (145) aufweist, das zwischen der Duschkopfplatte (120) und der Stützplatte (125) vorgesehen ist, um dadurch einen schmalen Spalt zwischen der Duschkopfplatte (120) und der Stützplatte (125) aufrechtzuerhalten.

5. Vakuumverarbeitungskammer nach einem der Ansprüche 1 bis 4, worin die Duschkopfplatte (120) ferner ein kreisförmiges Loch (152) und einen Bolzen (150) aufweist, der durch das kreisförmige Loch (152) hindurchtritt und die Duschkopfplatte (120) fest an der Stützplatte (125) befestigt.

6. Vakuumverarbeitungskammer nach einem der Ansprüche 2 bis 5, worin jedes der Vielzahl der ovalen Löcher (154) so orientiert ist, dass seine lange Achse entlang einer geraden Linie liegt, die sich radial von dem Mittelpunkt der Duschkopfplatte (120) erstreckt und durch das ovale Loch (154) hindurchtritt.

7. Vakuumverarbeitungskammer nach Anspruch 1, worin jede der Befestigungsanordnungen (150, 170, 173, 176, 177, 178) einen Schlüssel (171) aufweist, um nur eine Orientierung zu gestatten, wenn die Befestigungsanordnung (150, 170, 173, 176, 177, 178) mit ihrem jeweiligen ovalen Loch (154) abgedichtet ist.

8. Vakuumverarbeitungskammer nach Anspruch 1, worin die Kugellageranordnung umfasst:
einen Einsatz (170), der ein ovales Loch (172) darin hat;
eine Gleitplatte (173), die eine Vielzahl von nicht kreisrunden Löchern (174) darin hat;
eine Vielzahl von Kugeln (175), die jeweils einem der nicht kreisförmigen Löcher (174) entsprechen;
eine Deckplatte (176), die ein kreisförmiges Loch darin hat.

9. Vakuumverarbeitungskammer nach Anspruch 8, worin der Einsatz (170) ferner einen Schlüssel (171) aufweist, um den Einsatz innerhalb von einem der ovalen Löcher (154) der Duschkopfplatte (120) zu orientieren.

10. Vakuumverarbeitungskammer nach Anspruch 8, worin wenigstens der Einsatz (170) oder die Gleitplatte (173) oder die Vielzahl der Kugeln (175) oder die Deckplatte (176) aus Keramik hergestellt ist.

11. Vakuumverarbeitungskammer nach einem der Ansprüche 8 bis 10, ferner umfassend eine Abdeckplatte (160), um die Befestigungsanordnung (150, 170, 173, 176, 177, 178) abzudecken.

12. Vakuumverarbeitungskammer nach Anspruch 1, worin jede der Befestigungsanordnungen (150, 170, 173, 176, 177, 178) umfasst:
einen Einsatz (170), der ein ovales Loch (172) darin und eine Gleitfläche hat;
eine Deckplatte (176), die eine passende Oberfläche gegenüberliegend zu der Gleitfläche hat;
und
einen Bolzen (150), der durch den Einsatz (170) und die Deckplatte (176) hindurchtritt.

13. Vakuumverarbeitungskammer nach Anspruch 1, worin jede der Befestigungsanordnungen (150, 170, 173, 176, 177, 178) ferner eine Gleitplatte (173) umfasst, die zwischen dem Einsatz (170) und der Deckplatte (176) eingesetzt ist, worin die Gleitplatte vorzugsweise eine Teflonplatte aufweist.

14. Verfahren, um eine Duschkopfanordnung (120, 125) an einer Vakuumverarbeitungskammer (100) zu befestigen, umfassend:
festes Anbringen einer Stützplatte (125) an die Vakuumverarbeitungskammer (100);
Verankern von einer perforierten Duschkopfplatte (120) an der Stützplatte (120) unter Verwendung einer Vielzahl von Befestigungsanordnungen (150, 170, 173, 176, 177, 178), um die perforierte Duschkopfplatte (120) an der Stützplatte (125) gleitbar zu befestigen; und
Bereitstellen einer Gasdichtung zwischen der perforierten Duschkopfplatte (120) und der Stützplatte (125),
**dadurch gekennzeichnet, dass**
die gleitbare Befestigung das Verbolzen der perforierten Duschkopfplatte (120) an der Stützplatte (125) über eine Kugellageranordnung umfasst.

15. Verfahren nach Anspruch 14, ferner umfassend das Einsetzen eines Abstandsstücks (145) zwischen der perforierten Duschkopfplatte (120) und der Stützplatte (125).

16. Verfahren nach Anspruch 15, ferner umfassend das Orientieren von jeder der Kugellageranordnungen, sodass sie mit einer imaginären Linie ausgerichtet ist, die sich radial von dem Mittelpunkt der Duschkopfplatte (120) erstreckt.

17. Verfahren nach Anspruch 14, ferner umfassend das feste Verbinden der Duschkopfplatte (120) an der Stützplatte (125) an einem Punkt.

## Revendications

1. Chambre de traitement sous vide, comprenant:
- un corps de la chambre (102);
- un ensemble de pommeau de douche (120, 125) couplé à la portion supérieure du corps de chambre (102); et, où l'ensemble de pommeau de douche (120, 125) comprend:
- une plaque arrière (125) attachée de manière rigide au corps de chambre (102);
- une plaque de pommeau de douche perforée (120);
- une pluralité d'ensembles de fixation (150, 170, 173, 176, 177, 178) assurant par glissement la plaque de pommeau de douche (120) à la plaque arrière (125) de sorte que la plaque de pommeau de douche (120) puisse glisser à l'égard de la plaque arrière (125); où l'obturateur de gaz est maintenu entre la plaque de pommeau de douche (120) et la plaque arrière (125) **caractérisé en ce que**
chacun d'entre les ensembles de fixation (150, 170, 173, 176, 177, 178) comprend un ensemble de roulement à billes et un boulon (150) passant par l'ensemble de roulement à billes.

2. Chambre de traitement sous vide selon la revendication 1, où la plaque de pommeau de douche perforée (120) comprend une pluralité de trous ovales (154) à la périphérie de celle-ci, et où chacune de la pluralité d'ensembles de fixation (150, 170, 173, 176, 177, 178) est inséré dans un de la pluralité de trous ovales (154).

3. Chambre de traitement sous vide selon la revendication 1 ou 2, où l'ensemble de pommeau de douche (120, 125) comprend de plus un anneau-O (140) pourvu entre la plaque de pommeau de douche (120) et la plaque arrière (125).

4. Chambre de traitement sous vide selon la revendication 1, 2 ou 3 où l'ensemble de pommeau de douche (120, 125) comprend de plus une pièce de distance (145) pourvu entre la plaque de pommeau de douche (120) et la plaque arrière (125).

5. Chambre de traitement sous vide selon l'une quelconque des revendications 1 à 4, où la plaque de pommeau de douche (120) comprend de plus un trou circulaire (152) et un boulon (150) passant par le trou circulaire (152) et assurant de manière fixe la plaque de pommeau de douche (120) à la plaque arrière (125).

6. Chambre de traitement sous vide selon l'une quelconque des revendications 2 à 5, où chacune de la pluralité de trous ovales (154) est orienté de sorte que son axe longue se trouve le long d'une ligne droite s'étendant radialement du centre de la plaque de pommeau de douche (120) et passant par le trou ovale (154).

7. Chambre de traitement sous vide selon la revendication 1, où chacune des ensembles de fixation (150, 170, 173, 176, 177, 178) comprend un clef (171) pour permettre selon une orientation quand l'ensemble de fixation (150, 170, 173, 176, 177, 178) est assis dans son trou ovale correspondant (154).

8. Chambre de traitement sous vide selon la revendication 1, où l'ensemble de roulement à billes comprend:
- une insertion (170) ayant un trou ovale (172) là dedans;
- une plaque de glissement (173) ayant une pluralité de trous non circulaires (174) là dedans;
- une pluralité de billes (175), chacune pour une des trous non circulaires (174);
- une plaque de couvercle (176) ayant un trou circulaire là dedans.

9. Chambre de traitement sous vide selon la revendication 1, où l'insertion (170) comprend de plus un clef (171) pour orienter l'insertion à l'intérieur d'une des trous ovales (154) de la plaque de pommeau de douche (120).

10. Chambre de traitement sous vide selon la revendication 1, où au moins l'un d'entre l'insertion (170), la plaque de glissement (173), la pluralité de billes (175), et la plaque de couvercle (176), est fait en céramique.

11. Chambre de traitement sous vide selon l'une quelconque des revendications 8 à 10, comprenant de plus une plaque de couvercle (160) pour couvrir l'ensemble de fixation (150, 170, 173, 176, 177, 178).

12. Chambre de traitement sous vide selon la revendication 1, où chacun de l'ensemble de fixation (150, 170, 173, 176, 177, 178) comprend:
- une insertion (170) ayant un trou ovale (172) là dedans et une surface de glissement;
- une plaque de couvercle (176) ayant une surface conjuguée tournée vers la surface de glissement; et,
- un boulon (150) passant par l'insertion (170) et la plaque de couvercle (176).

13. Chambre de traitement sous vide selon la revendication 1, où chacun d'entre les ensembles de fixation (150, 170, 173, 176, 177, 178) comprend de plus une plaque de glissement (173) insérée entre l'insertion (170) et la plaque de couvercle (176), où la plaque de glissement (173) comprend préférablement une plaque de teflon.

14. Procédé pour assurer un ensemble de pommeau de douche (120, 125) sur une chambre de traitement sous vide (100), comprenant:
- attacher de manière fixe une plaque arrière (125) à la chambre de traitement sous vide (100);
- coupler une plaque de pommeau de douche perforée (120) à la plaque arrière (125) en utilisant une pluralité d'ensembles de fixation (150, 170, 173, 176, 177, 178) pour attacher par glissement la plaque de pommeau de douche perforée (120) à la plaque arrière (125); et
- pourvoir un obturateur de gaz entre la plaque de pommeau de douche perforée (120) à la plaque arrière (125)
**caractérisé en ce que**
attacher par glissement comprend fixer par boulon la plaque de pommeau de douche perforée (120) à la plaque arrière (125) par un ensemble de roulement à billes.

15. Procédé selon la revendication 14, comprenant de plus une pièce de distance (145) entre la plaque de pommeau de douche perforée (120) et la plaque arrière (125).

16. Procédé selon la revendication 15, comprenant de plus chacune des ensembles de roulement à billes de sorte qu'il soit aligné avec une ligne imaginaire s'étendant radialement du centre de la plaque de pommeau de douche (120).

17. Procédé selon la revendication 14, comprenant de plus fixer de manière fixe la plaque de pommeau de douche (120) à la plaque arrière (125) à un point.
